(19) Europäisches Patentamt
European Patent Office
Office européen des brevets

(11) **EP 2 106 622 B1**

(12) **EUROPÄISCHE PATENTSCHRIFT**

(45) Veröffentlichungstag und Bekanntmachung des Hinweises auf die Patenterteilung:
**01.12.2010 Patentblatt 2010/48**

(51) Int Cl.:
***H01L 41/04*** *(2006.01)*     ***G06F 17/50*** *(2006.01)*

(21) Anmeldenummer: **08860191.9**

(22) Anmeldetag: **10.10.2008**

(86) Internationale Anmeldenummer:
**PCT/DE2008/075007**

(87) Internationale Veröffentlichungsnummer:
**WO 2009/074152 (18.06.2009 Gazette 2009/25)**

(54) **VORRICHTUNG UND VERFAHREN ZUR EMULATION EINES AKTORS**

DEVICE AND METHOD FOR EMULATING AN ACTUATOR

DISPOSITIF ET PROCÉDÉ D'ÉMULATION D'UN ACTIONNEUR

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **11.10.2007 DE 102007049023**

(43) Veröffentlichungstag der Anmeldung:
**07.10.2009 Patentblatt 2009/41**

(73) Patentinhaber: **Schemmer, Benedikt**
**63303 Dreieich (DE)**

(72) Erfinder: **Schemmer, Benedikt**
**63303 Dreieich (DE)**

(74) Vertreter: **Kopf, Korbinian Paul et al**
**Maiwald Patentanwalts GmbH**
**Elisenhof**
**Elisenstrasse 3**
**80335 München (DE)**

(56) Entgegenhaltungen:
**EP-A- 0 155 694**     **DE-A1- 10 063 535**
**DE-A1- 10 158 584**     **JP-A- 4 140 080**
**JP-A- 2005 164 369**

- **DUAN ET AL: "Finite element solution for intermittent-contact problem with piezoelectric actuation in ring type USM" FINITE ELEMENTS IN ANALYSIS AND DESIGN, ELSEVIER, AMSTERDAM, NL, Bd. 43, Nr. 3, 12. Dezember 2006 (2006-12-12), Seiten 193-205, XP005882563 ISSN: 0168-874X**

**Beschreibung**

Die Erfindung betrifft eine Vorrichtung zur Emulation zumindest eines Antriebs sowie ein Verfahren zur Emulation eines Antriebs, insbesondere unter Verwendung einer erfindungsgemäßen Vorrichtung.

Für die Entwicklung von Aktoren, insbesondere piezoelektrischen Aktoren, stehen verschiedene Verfahren zur Verfügung: analytische Modellierung, Finite-Elemente-Methode (FEM), Simulation und der Test mit Prototypen. Jedes Verfahren hat seine Vorteile: die analytische Modellierung gewährt den tiefsten Einblick in die grundlegenden Mechanismen des Aktors. Allerdings ist es schwer oder auch unmöglich, alle wirkenden Effekte zu kennen und zu modellieren. Die FEM-Simulation erlaubt es sehr einfach, Parameter- Variationen durchzuführen und eine reibschlüssige Kraftübertragung an eine mit dem Aktor verbundene Last zu simulieren. Die Simulation ist hierbei jedoch nur so gut, wie die zu Grunde gelegten Modelle. So sind gängige Simulationsprogramme (ANSYS, ABAQUS) z.B. nicht in der Lage nichtlineare Effekte, beispielsweise einer Piezokeramik, zu simulieren.

Der Test von Prototypen erlaubt die schnelle und pragmatische Prüfung von in den beiden vorhergehenden Verfahren getroffenen Annahmen in der Realität. Allerdings sind die durch die Fertigung bzw. durch das Material entstehenden Toleranzen des Prototyps in der Regel nicht vollständig erfassbar. Weiterhin ist es im Allgemeinen aus Kosten- und Zeitgründen nicht möglich, einen Aktor erschöpfend zu betrachten. Üblicherweise werden nur einige wenige neue Aktoren (mitunter nur ein einzelner Aktor) simuliert, aufgebaut und vermessen.

Aus dem Stand der Technik sind Vorrichtungen bekannt, mit denen verschiedene Belastungssituationen unter Einsatz eines Aktors emuliert werden können. So offenbart die JP 04 140 080 A eine Vorrichtung und Verfahren zur Durchführung eines Abriebstests eines Ultraschallmotors.
Über einen piezoelektrischen Vibrator werden Vibrationen auf einen Stator ausgeübt, der im schleifenden Kontakt mit einem durch einen Motor angetriebenen Rotor steht. Dies ermöglicht es, eine Abriebsituation wie sie unter realen Bedingungen erfolgt, zu emulieren.

Eine ähnliche Abrasionstestseinrichtung ist der JP 2005 164 369 A zu entnehmen. Mittels eines Gewichts wird ein zu testendes Element gegen einen Rotor gedrückt. Dabei wird der Anpressdruck des Testelements gegen den Rotor mittels eines piezoelektrischen Elements, umfassend einen Vibrator, verändert.
Diese aus der JP 04 140 080 A und JP 2005 164 369 A bekannten Vorrichtungen erlauben es jedoch nicht, Daten, die für die Entwicklung eines Aktors, insbesondere eines piezoelektrischen Aktors, benötigt werden, zu bestimmen.

Es ist daher Aufgabe der vorliegenden Erfindung eine Vorrichtung und ein Verfahren zur Emulation eines geplanten Antriebs bereitzustellen, die es auf einfache und kostengünstige Weise erlauben, Vorhersagen über das Verhalten des geplanten Antriebs treffen zu können. Insbesondere soll eine Vorrichtung und ein Verfahren bereitgestellt werden, die es ermöglichen, das Verhalten des geplanten Antriebs unabhängig von Fertigungstoleranzen so umfänglich wie möglich nachahmen zu können.

Die die Vorrichtung betreffende Aufgabe wird gelöst durch eine Vorrichtung gemäß Anspruch 1.

Weitere Ausführungsformen gehen aus den abhängigen Ansprüchen 2-9 hervor.

Die das Verfahren betreffende Aufgabe wird gelöst durch ein Verfahren gemäß Anspruch 10.

Weitere Ausführungsformen ergeben sich aus den abhängigen Ansprüchen 11-18.

Der Erfindung liegt somit die überraschende Erkenntnis zugrunde, dass eine Entwicklung eines geplanten ersten Aktors vereinfacht werden kann und gleichzeitig bessere Vorhersagen über das Verhalten dieses geplanten Aktors getroffen werden können, indem eine Vorrichtung und ein Verfahren zur Emulation des ersten Aktors bereitgestellt wird, bei dem in der analytischen oder FEM - Beschreibung oder durch Vermessen eines Prototypen gefundene Parameter des ersten bzw. zu emulierenden Aktors in ein mechanisches System. überführt werden, welches ein reproduzierbares Verhalten aufweist. Dabei umfasst die Vorrichtung zur Emulation bzw. Nachahmung einen elektrischen und einen mechanischen Teil, welche über eine erste Steuer- und/oder Regeleinheit, wie einen Mikrocontroller, miteinander verbunden sind.
Der elektrische Teil in Form eines elektrischen Netzwerks dient dazu, eine Impedanz des emulierten ersten Aktors nachzuahmen, während der mechanische Teil, der einen zweiten piezoelektrischen Aktor umfasst, die Bewegung des Aktors bezogen auf den Berührungspunkt zum angetriebenen Körper (=Last) nachahmt.

Im Unterschied zu einer Simulation werden durch die erfindungsgemäße Vorrichtung und das erfindungsgemäße Verfahren auch mit Simulationsprogrammen nicht erfassbare Effekte, wie nicht lineare Effekte einer Piezokeramik, mit emuliert bzw. nachgeahmt. Grund hierfür ist, dass eine Simulation an einem PC mit einem virtuellen System durchgeführt wird, während gemäß der erfindungsgemäßen Vorrichtung und dem erfindungsgemäßen Verfahren eine Nachahmung des Verhaltens des geplanten ersten Aktors mit einem Emulator, der einen realen, funktionsfähigen Aktor und eine reale, elektronisch veränderliche, Impedanz umfasst, durchgeführt wird.

Bei einer Ausführungsform des erfindungsgemäßen Verfahrens ist folgender Ablauf vorgesehen: Anhand von analytischen bzw. FEM-Berechnungen oder anhand von durch Vermessung eines Prototyps des geplanten Aktors gewonnenen Daten werden Parameter eines elektrischen Ersatzschaltbildes des geplanten, insbesondere piezoelektrischen, Aktors berechnet und an eine erste Steuer- und Regeleinheit, insbesondere umfassend zumindest einen Mikrocontroller, übergeben, die daraufhin das elektrische Netzwerk entsprechend anpasst. Die Kopplung zwischen dem elektrischen Netzwerk und dem zweiten, insbesondere piezoelektrischen, Aktor kann (falls gewünscht) durch eine berechnete Wandlerkonstante vorgegeben werden. Da die beiden Emulatorteile nicht starr gekoppelt sind, können sie auch vollständig unabhängig voneinander genutzt werden.

Zur Durchführung der Emulation des geplanten Aktors kann eine Bewegung des zweiten Aktors, insbesondere einer mit einem zweiten piezoelektrischen Aktor verbindbare Spitze, vorgegeben werden. Die Bewegung des zweiten Aktors bzw. der Spitze wird über Sensoren erfasst. Dadurch ist es möglich, eine beliebige Trajektorie zu durchfahren. Das Durchfahren mit beliebigen Trajektorien an einem realen bzw. emulierenden Aktor in Form des zweiten Aktors bietet den Vorteil, dass im Vergleich zu einer Vermessung eines Prototypen eines geplanten Aktors Fertigungstoleranzen des Emulators kompensiert werden und nicht mehr ins Gewicht fallen. Insbesondere können verschiedene Eigenschaften, wie Kraft, Steifigkeit und Bewegungsabläufe, von bestehenden Aktoren nachgeahmt (emuliert) werden und darüber hinaus Eigenschaften von neuen Aktoren vorhergesagt werden. Zusätzlich können lastbedingte Kräfte erfasst werden und in das elektrische Netzwerk (im einfachsten Fall als einstellbare Dämpfung) zurückgeführt werden.

Die vorliegende Erfindung vereinfacht somit die Entwicklung von, insbesondere piezoelektrischen, Aktoren, da auf vergleichsweise einfache Weise Informationen über das voraussichtliche Verhalten des geplanten Aktors gewonnen werden können und dessen Verhalten entsprechend angepasst werden kann. So kann beispielweise aufgrund der durch die Emulation gewonnenen Daten eine Ansteuerelektronikschaltung des geplanten piezoelektrischen Aktors angepasst werden, um eine Ansteuerung des geplanten Aktors im Resonanzbereich sicherzustellen. Dadurch lassen sich insbesondere Verschleißerscheinungen des geplanten, insbesondere piezoelektrischen, Aktors minimieren, da so vermieden werden kann, dass es aufgrund einer unzureichenden Auslenkung des Aktors zu Abrieberseheinungen zwischen dem Aktor und einer zu bewegenden Last kommt.

Weiterhin lässt sich beispielsweise ein Entwurfsprozess für einen piezoelektrischen Aktor zur Entwicklung eines neuartigen Instruments für die Medizintechnik effizienter gestalten. Dabei weisen insbesondere piezoelektrische Antriebe bei dem geringen verfügbaren Bauvolumen eines intrakorporalen Manipulators Vorzüge auf. Im Vergleich zu elektrodynarnischen Aktoren ist jedoch der Entwurfsprozeß für einen piezoelektrischen Antrieb deutlich aufwendiger und komplizierter. Aus den zuvor angeführten Gründen führt die Erfindung insbesondere bei der Entwicklung von piezoelektrischen Aktoren für Medizintechnikinstrumente zu deutlichen Vorteilen.

Insbesondere in dem angestrebten Leistungsdichtebereich von 40 kW/m$^3$ in Kombination mit dem vorhandenen Bauvolumen von etwa 1000 mm$^3$ sind bisher keine Aktoren mit Leistungsdaten von 5 N bei 20 mm/s bekannt, so dass diese von Grund auf neu entwickelt werden müssen.

Durch die vorliegende Erfindung wird insbesondere der bei den bisherigen Entwicklungsprozessen vorliegende Schwachpunkt überwunden, dass die auf Simulations- bzw. Modellierungsverfahren basierenden Entwicklungsprozesse für einen Aktor keine ausreichende, insbesondere mechanische, Kopplung zwischen der Simulation und einem realen Aktor erreichen.

Weitere Merkmale und Vorteile der Erfindung ergeben sich aus der nachfolgenden Beschreibung, in der Ausführungsbeispiele der Erfindung anhand von schematischen Zeichnungen im Einzelnen erläutert werden.

Dabei zeigt:

Figur 1 ein schematisches Blockschaltbild einer erfindungsgemäßen Vorrichtung

Figur 2a eine perspektivische Aufsicht auf eine erfindungsgemäße Vorrichtung mit einer translatorisch zu bewegenden Last;

Figur 2b eine perspektivische Aufsicht auf die erfindungsgemäße Vorrichtung der Figur 2a mit einer rotatorisch zu bewegenden Last;

Figur 3 eine Aufsicht auf die Vorrichtung der Figur 22. bzw. der Figur 2b;

Figur 4a ein Wandlerersatzschaltbild eines allgemeiner. Aktors;

Figur 4b ein Wandlerersatzschaltbild eines piezoelektrischen Aktors;

Figur 5 eine erste Ausführungsform eines elektrischen Netzwerks einer erfindungsge- mäßen Vorrichtung;

Figur 6 eine zweite Ausführungsform eines elektrischen Netzwerks einer erfindungs- gemäßen Vorrichtung mit einem einstellbaren Widerstand;

Figur 7 ein Schaltbild einer möglichen Realisierung eines einstellbaren Widerstands des elektrischen Netzwerks der Figur 6;

Figur 8    ein Schaltbild einer in einer erfindungsgemäßen Vorrichtung verwendbaren Kapazitätseinrichtung zur Einstellung unterschiedlicher Kapazitätswerte;

Figur 9    eine Auftragung verschiedener mit einem zweiten piezoelektrischen Aktor ei- ner erfindungsgemäßen Vorrichtung durchfahrbarer Trajektorien; und

Figur 10    ein schematisches Blockschaltbild einer weiteren Ausführungsform einer erfin- dungsgemäßen Vorrichtung.

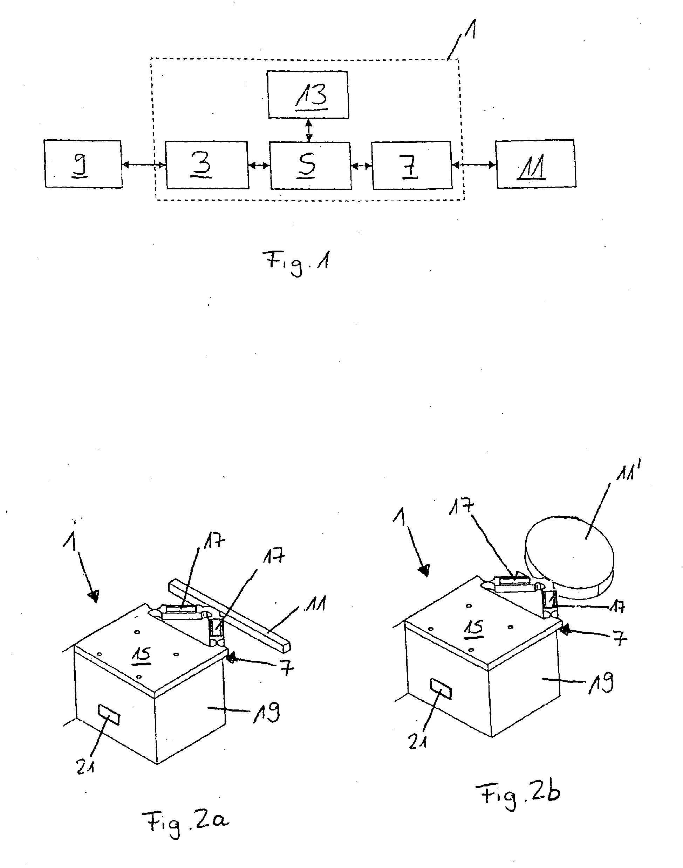

Anhand der Figuren 1 bis 9 wird im Folgenden die erfindungsgemäße Vorrichtung und das erfindungsgemäße Verfahren anhand der Emulation eines piezoelektrischen Aktors erläutert.

In Figur 1 ist der schematische Aufbau einer erfindungsgemäßen Vorrichtung in Form eines Emulators 1 dargestellt. Der Emulator 1 dient insbesondere zur Emulation eines Verhaltens eines ersten piezoelektrischen Antriebs bzw. Aktors, der insbesondere noch entwickelt wird.

Zur Emulation des Verhaltens des ersten bzw. zu emulierenden piezoelektrischen Aktors weist der Emulator 1 ein elektrisches Netzwerk 3, welches über eine erste Steuer- und/oder Regeleinheit in Form eines Mikrocontrollers 5 mit einem zweiten piezoelektrischen Aktor 7 verbunden ist, auf. Das elektrische Netzwerk 3 ist mit einer Ansteuerelektronikschaltung 9 verbindbar. Ferner ist der zweite piezoelektrische Aktor 7 mit einer Last 11 verbindbar. Der Emulator 1 weist darüber hinaus eine zweite Steuer- und/oder Regeleinheit in Form eines Computerterminals bzw. PCs 13 auf. Obwohl in Figur 1 lediglich eine Kommunikationsmöglichkeit des PCs 13 mit dem Mikrocontroller 5 angedeutet ist, ermöglicht es der PCs 13 über eine nicht dargestellte Verbindung mittels der Ansteuerelektronikschaltung 9 Ansteuersignale für den Emulator 1 zu erzeugen. Wie im Nachfolgenden erläutert werden wird, ermöglicht es der Emulator 1 das Verhalten des ersten piezoelektrischen Aktors, der anstelle des Emulators 1 mit der Ansteuerelektronikschaltung 9 und der Last 11 in späteren Anwendungen verbunden wird, nachzuahmen.

In Figur 2a ist eine Aufsicht auf eine mögliche Realisierungsform des Emulators 1 der Figur 1 dargestellt. In dem in Figur 2 dargestellten Gesamtaufbau sind die Elektronik für die einstellbare elektrische Impedanz sowie die Elektronik zur Steuerung und/oder Regelung des Aktors sowie von Wegsensoren untergebracht. Wie in Figur 2a ersichtlich, umfasst dabei der zweite piezoelektrische Aktor 7 einen Antriebsgrundkörper 15, an dem zwei piezoelektrische Antriebseinrichtungen in Form von Stapelaktoren 17 angeordnet sind. Der piezoelektrische Aktor 7 ist über eine in Figur 2a nicht dargestellte Verbindungsvorrichtung in Form einer auswechselbaren Spitze mit einer Last 11, insbesondere zur Bewegung der Last 11, in Kontakt bringbar. Die in der Figur 2a dargestellte Last 11 wird durch den Emulator 1 bzw. den zweiten Aktor 7 translatorisch bewegt.

In Figur 2b ist eine Kombination des Emulators 1 der Figur 2a mit einer Last 11' dargestellt. Bei der Last 11' handelt es sich um eine rotatorisch zu bewegende Last. Im Gegensatz zur im Wesentlichen stiftförmigen Last 11 ist die Last 11' scheibenförmig.

Bei der Last 11, 11' kann es sich insbesondere um ein Keramikelement handeln, während die Verbindungsvorrichtung in Form einer auswechselbaren Metallspitze ausgebildet sein kann. Unterhalb des Antriebsgrundkörpers 15 ist ein Gehäuse 19 zur Aufnahme des elektrischen Netzwerks 3 sowie des Mikrocontrollers 5 angeordnet. Die in dem Gehäuse 19 angeordneten Elemente sind über eine Schnittstelle 21, beispielsweise einen USB - Anschluss, mit dem in den Figuren 2a und 2b nicht dargestellten PC 13 verbindbar.

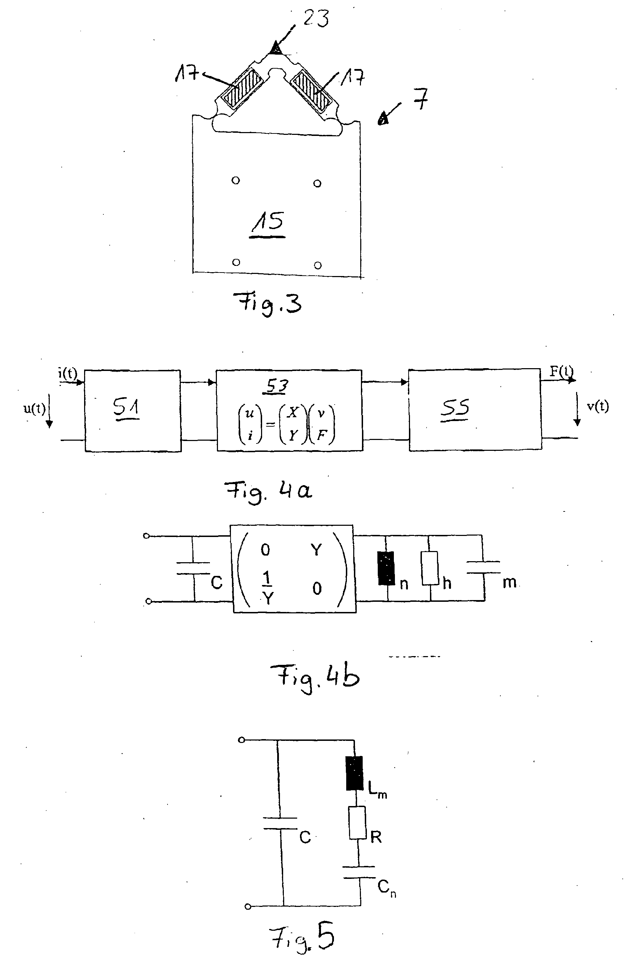

Anhand der Figur 3 wird nun im Folgenden die Funktionsweise des zweiten piezoelektrischen Aktors 7 der Figuren 2a und 2b erläutert. Insbesondere ist in Figur 3 die Verbindungsvorrichtung in Form einer austauschbaren metallischen Spitze 23, die mit einer in Figur 3 nicht dargestellten Last in Kontakt bringbar ist, dargestellt. Der in Figur 3 dargestellte piezoelektrische Aktor 7 ermöglicht insbesondere die Emulation von Aktoren mit einem punkt- oder linienförmigen Einzelkontakt zu einer Last. Wie bereits zuvor erwähnt, umfasst der piezoelektrische Aktor 7 im Wesentlichen einen Mechanismus, in dem zwei piezoelektrische Stapelaktoren 17 eingesetzt werden. Die Stapelaktoren 17 können unabhängig voneinander betrieben werden. Um zu ermöglichen, dass eine Vielzahl von unterschiedlichen Bewegungen bzw. Trajektorien mit der auswechselbaren Spitze 23 durchgefahren werden können, werden die Stapelaktoren unabhängig voneinander und nicht in Resonanz betrieben. Insbesondere ist der piezoelektrische Aktor 7 so ausgelegt, dass die Spitze eine kreisförmige, symmetrische Bewegung ausführen kann, wobei eine Auslenkung der Spitze 23 vorzugsweise im Bereich von 10 $\mu$m aus einer Ruheposition liegen kann. Um das Durchfahren einer vorbestimmten Bewegung bzw. Trajektorie mit dem zweiten piezoelektrischen Aktor 7 zu ermöglichen, ist vorgesehen, dass neben einer reinen Steuerung der Stapelaktoren 17 des Emulators 1 eine Regelung der Bewegung der Spitze 23 bzw. der Stapelaktoren 17 durchgeführt wird. Eine derartige Regelung ist insbesondere notwendig, um Bewegungsänderungen zu beachten, die sich durch eine Veränderung der Belastung der Spitze bei Durchfahren der vorbestimmten Trajektorie ergeben können.

Bei Durchführung dieser Regelung ist vorgesehen, dass der piezoelektrische Aktor 7 Sensoren, die insbesondere in Form von kapazitiven Wegsensoren realisiert sein können, aufweist. Diese in Figur 3 nicht dargestellten Sensoren ermöglichen es, eine Bewegung der Spitze 23 bis auf einige Nanometer genau zu erfassen. Der Einsatz der Sensoren bietet ferner den Vorteil, dass, sobald eine Bewegung der Spitze 23 erfasst werden kann, eine Geschwindigkeit und eine Beschleunigung der Spitze 23 berechenbar ist. Bei Kenntnis dieser Größen wird es dann möglich an der Spitze 23, insbesondere bei Kontakt mit einer Last, wirkende Kräfte zu berechnen, und daraus die Leistung zu berechnen, die aufgebracht werden muss, um eine gewünschte Bewegung der Spitze 23 auszuführen.

Aufgrund des zuvor angeführten Aufbaus des piezoelektrischen Aktors 7 ermöglicht eine Regelung, die trotz zum Teil extrem hoher Frequenzen der Bewegung der Spitze 23, die im Bereich von ungefähr 100 kHz liegen kann, eine Einregelung der Bewegung der Spitze 23 durch eine durch mehrere Stützstellen vorgegebene Trajektorie, so dass es aufgrund der bekannten Werte von Weg, Geschwindigkeit und Beschleunigung möglich ist, eine Trajektorie nicht nur im Mittel von einzelnen Schwingungsvorgängen vorzugeben, sondern jede einzelne Trajektorie exakt und für jeden Durchlauf einzuhalten.

Kerngedanke der vorliegenden Erfindung ist es, dass das Verhalten des geplanten piezoelektrischen Aktors mittels des real existierenden zweiten piezoelektrischen Aktors 7 nachgeahmt bzw. emuliert wird, wobei das elektrische Netzwerk 3 dazu dient, die elektrischen Eigenschaften des ersten piezoelektrischen Aktors nachzuahmen, insbesondere eine elektrische Impedanz des geplanten piezoelektrischen Aktors für die Ansteuerelektronikschaltung 9 bereitzustellen. Ausgehend von einem in Figur 4a dargestellten Wandlerersatzschaltbild kann zur Bestimmung der Parameter des elektrischen Netzwerks 3 von einem vereinfachten, in Figur 4b dargestellten, Wandlerersatzschaltbild für piezoelektrische Wandler bzw. Aktoren ausgegangen werden.

Gemäß dem in Figur 4a dargestellten Wandlerersatzschaltbild wird an ein elektrisches Netzwerk 51 ein Ansteuerungssignal in Form einer Spannung u(t) und eines Stroms i(t) angelegt. Das elektrische Netzwerk 51 vereint die elektrischen Eigenschaften des Wandlers bzw. Aktors in sich. Das elektrische Netzwerk 51 ist über einen Kopplungsvieipol 53 mit einem mechanischen Netzwerk 55 verbunden, welches die Erzeugung eines Ausgangssignals in Form einer Kraft F(t) und Geschwindigkeit v(t) bewirkt. Dieses Wandlerersatzschaltbild erlaubt die Beschreibung beliebiger Wandler bzw. Aktoren, wobei das elektrische Netzwerk kapazitive Eigenschaften, induktive Eigenschaften und ohmsche Widerstandseigenschaften aufweisen kann. Diese können bei einer Umsetzung in ein reales Netzwerk durch passive und/oder aktive Bauelemente realisiert sein. So kann das elektrische Netzwerk zur Emulation eines elektrischen Motors eine Nachbildung einer Motorsteuerung umfassen. Mittels des Kopplungsvierpols 53 erfolgt eine Transformation des am Ausgang des elektrischen Netzwerks 51 anliegenden Spannungssignals u und Stromsignals i mittels eines transformatorischen Kopplungsfaktors X und eines gyratorischen Kopplungsfaktors Y in Geschwindigkeitswelle v und Kraftwerte F.

In dem Wandlerersatzschaltbild der Figur 4b für einen piezoelektrischen Aktor stellt die Eingangskapazität C die elektrische Kapazität des geplanten Aktors dar, während die Nachgiebigkeit n, den mechanische Mitgang h sowie die Masse m die mechanischen Eigenschaften des geplanten Aktors vereinfacht darstellen. Y stellt die Wandlerkonstante des piezoelektrischen Aktors dar, wobei diese nach

$$Y = \frac{s^E}{d} \cdot \frac{l_{mech}}{A_{el}}$$

bestimmt werden kann. Hierbei stellt $S^E$ die Dehnung des piezoelektrischen Aktors bei einem konstanten elektrischen Feld dar, d die piezoelektrische Ladungskonstante, d.h. die Ausdehnung des piezoelektrischen Aktors pro Spannungseinheit, $l_{mech}$ die Dicke des piezoelektrischen Materials und $A_{el}$ die Fläche der mit dem piezoelektrischen Material verbundenen Elektrode. Dabei wird davon ausgegangen, dass

$$A_{el} \cdot l_{el} = A_{mech} \cdot l_{mech}$$

gilt, wobei $l_{el}$ den Abstand zwischen Elektroden des piezoelektrischen Elements darstellt und $A_{mech}$ die Fläche des piezoelektrischen Materials repräsentiert. Somit ist die Wandlerkonstante Y im Wesentlichen durch die geometrischen Eigenschaften und die Eigenschaften der Piezokeramik des geplanten piezoelektrischen Aktors vorgegeben und lässt sich durch Simulationsberechnungen bzw. Vermessungen eines Prototypen des geplanten piezoelektrischen Aktors bestimmen.

In Figur 5 ist eine elektronische Realisierung des Wandlerersatzschaltbildes der Figur 4 dargestellt. Die in Figur 5 dargestellte Schaltung stellt eine mögliche Ausführungsform des elektrischen Netzwerks 3 dar, wobei die Schaltung eine Elementarzelle darstellt. Diese Elementarzelle umfasst insbesondere eine erste Kapazitätseinrichtung in Form eines Kondensators C zu der parallel eine Reihensschaltung aus einer ersten Induktivitätseinrichtung in Form einer Induktivität $L_m$, einer zweiten Kapazitätseinrichtung in Form eines Kondensators $C_n$ und einer Widerstandseinrichtung in Form eines ohmschen Widerstands R geschaltet ist. Diese Schaltung des elektrischen Netzwerks 3 verdeutlicht, dass es sich bei einem piezoelektrischen Aktor um einen Gyrator handelt. Dies bedeutet, dass der piezoelektrische Aktor einen Dualinverter darstellt, also bei einer kapazitiven Ausgangsbelastung ein induktives Eingangsverhalten vorhanden ist, während bei einer induktiven Ausgangsbelastung ein kapazitives Eingangsverhalten vorhanden ist.

Bei Durchführung einer Emulation des geplanten piezoelektrischen Aktors wird gemäß dem erfindungsgemäßen Verfahren zunächst ein erster Parameter des elektrischen Netzwerks 3 eingestellt. Hierzu werden insbesondere die Kapazitäten C, $C_n$, die Induktivität $L_m$ sowie der Widerstand R eingestellt. Dies erfolgt insbesondere einmalig vor Durchführung eines Emulationsvorganges, wobei diese Werte insbesondere aus der Wandlerkonstante Y des zu entwickelnden piezoelektrischen Aktors bestimmt werden können. Zur Bestimmung der Parameter des elektrischen Netzwerks 3 können alternativ oder zusätzlich weitere vor der Emulation bekannte Parameter des geplanten Aktors herangezogen werden. Die Wandlerkonstante wird insbesondere durch Simulationsberechnungen des ersten piezoelektrischen Aktors bestimmt oder durch Vermessung eines Prototypen des ersten piezoelektrischen Aktors ermittelt. Das elektrische Netzwerk 3 wird insbesondere dadurch eingestellt, dass die Wandlerkonstante über den PC 13 an den Mikrocontroller 5 weitergegeben wird, der dann eine entsprechende Anpassung der Einzelelemente des elektrischen Netzwerks 3 vornimmt. Bei einer nachfolgenden Emulation des geplanten ersten piezoelektrischen Aktors werden an den Emulator über die Ansteuerelektronikschaltung 9 entsprechende Signale zur Bewegung des zweiten piezoelektrischen Aktors 7 entlang einer vorgegebenen Trajektorie angelegt. Dies ermöglicht es, dass bisher nicht simulierte Bewegungsformen des ersten piezoelektrischen Aktors von dem zweiten piezoelektrischen Aktor 7 durchfahren werden, also der zweite Aktor 7 eine Bewegung des geplanten piezoelektrischen Aktors nachahmt. Mittels des Emulators 1 kann so eine voraussichtliche Reaktion des geplanten ersten piezoelektrischen Aktors bei vorbestimmten Ansteuersignalen bestimmt werden.

Die in Figur 5 dargestellte Ausführungsform des elektrischen Netzwerks stellt eine Grundform zur Einstellung statischer Parameter des Emulators 1 dar. In nicht dargestellten Ausführungsformen kann vorgesehen sein, dass das elektrische Netzwerk eine Vielzahl von in Reihe geschalteten Elementarzellen, wie sie in Figur 5 dargestellt sind, aufweist. Dies ermöglicht es insbesondere, dass nicht nur eine Resonanzfrequenz des ersten piezoelektrischen Aktors emuliert werden kann, sondern auch Oberwellenresonanzen mittels des Emulators 1 emuliert werden können.

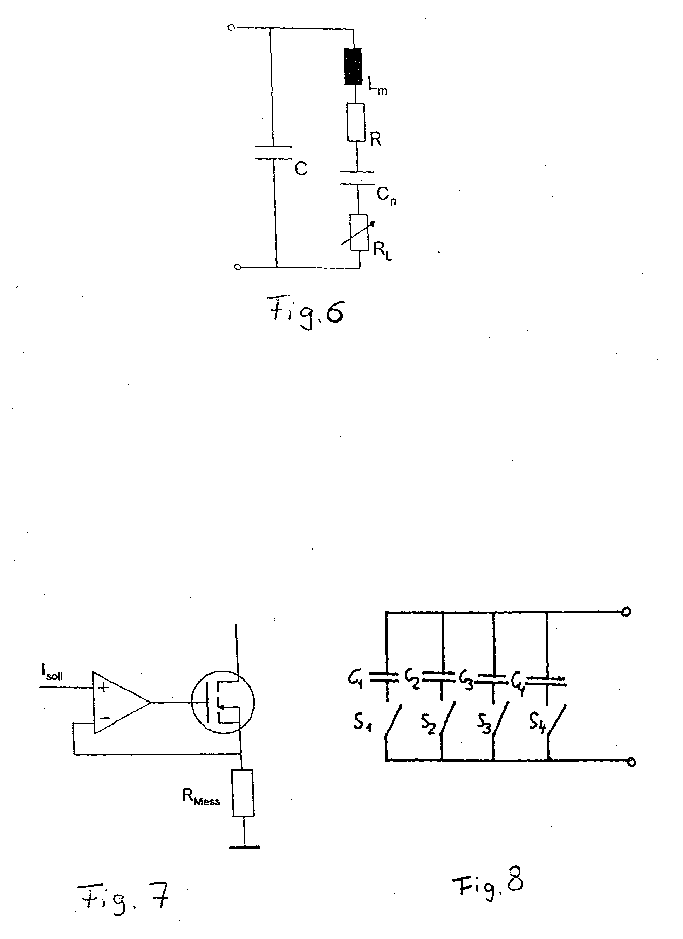

Des Weiteren ermöglicht es der Emulator 1, dass Lastzustände des ersten piezoelektrischen Aktors emuliert bzw. nachgeahmt werden können. Eine derartige Nachahmung wird insbesondere durch die in Figur 6 dargestellte Erweiterung des elektrischen Netzwerks erreicht. In das elektrische Netzwerk 3 wird eine zweite elektrische Widerstandseinrichtung in Form eines veränderlichen Widerstands $R_L$ eingefügt. Um einen piezoelektrischen Aktor emulieren zu können, wird der Widerstandswert des veränderlichen Widerstands $R_L$ während der Durchführung eines Emulationsvorgangs mittels des Mikrocontrollers 5 verändert. Diese Veränderung kann insbesondere aufgrund durch eine Wegmessung der Spitze zur Verfügung stehende Daten erfolgen. Wie bereits zuvor erläutert, ermöglicht es die Wegmessung eine Geschwindigkeit und Beschleunigung der Spitze zu berechnen, woraus, insbesondere bei Kenntnis einer an die Spitze angelegten Last, eine an der Spitze wirkende Kraft und eine für eine Bewegung der Spitze notwendige Leistung berechnet werden kann. Dies ermöglicht eine Rückkopplung auf die elektrische Seite des Emulators in Form des elektrischen Netzwerks vorzunehmen, indem die Last als variabler Widerstand in das elektrische Netzwerk aufgenommen wird. So können beispielsweise Laststöße oder schwingende Lasten nachgeahmt werden. Darüber hinaus kann durch den Emulationsvorgang zumindest ein dritter Parameter des geplanten ersten piezoelektrischen Aktors, der mittels einer Simulation oder einer Vermessung eines Prototyps des ersten piezoelektrischen Aktors nicht oder nur unzureichend bestimmt werden kann, ermittelt werden. Hierbei kann es sich beispielsweise um einen Parameter handeln, der nichtlineare Effekt der Piezokeramik des geplanten Aktors betrifft. Der so ermittelte dritte Parameter kann insbesondere verwendet werden, um in einer erneuten Simulation des geplanten ersten piezoelektrischen Aktors eingesetzt zu werden, um eine noch präzisere Simulation des geplanten ersten piezoelektrischen Aktors zu ermöglichen.

In den Figuren 7 und 8 sind Möglichkeiten der Realisierung des veränderlichen Widerstands $R_L$ (Figur 7) und der Kapazitätseinrichtung der Schaltung der Figuren 5 und 6 (Figur 8) dargestellt. Vorteilhafterweise wird der veränderliche Widerstand $R_L$ gemäß Figur 7 durch einen gesteuerten Halbleiter, z.B. einen MOSFET realisiert. Die jeweiligen Kapazitätseinrichtungen der Schaltungen der Figuren 5 und 6 sind gemäß Figur 8 beispielsweise durch ein Netzwerk von Einzelkondensatoren $C_1$, $C_2$, $C_3$, $C_4$ realisierbar. So kann beispielsweise der Kondensator $C_1$ einen Kapazitätswert von 1 $\mu$F, der Kondensator $C_2$ einen Kapazitätswert von 2 $\mu$F, der Kondensator $C_3$ einen Kapazitätswert von 4 $\mu$F und der Kondensator $C_4$ einen Kapazitätswert von 8 $\mu$F aufweisen. Durch geeignete Betätigung von Schaltungseinrichtungen $S_1$, $S_2$, $S_3$, $S_4$ lassen sich auf diese Weise verschiedene Kapazitätswerte realisieren. So kann bei Betätigung der Schalteinrichtungen $S_4$ und $S_1$ ein Kapazitätswert von 5 $\mu$F eingestellt werden. Hieraus wird deutlich, dass die Kapazitätseinrichtungen C, $C_n$, die bzw. Induktivitätseinrichtung $L_m$ und die Widerstandseinrichtung R aus einem veränderlich verschalteten Netzwerk von Widerständen, Kondensatoren und/oder Induktivitäten realisiert werden können. Durch geeignete Verschaltung der Elemente des Netzwerks kann die durch die analytische Beschreibung des ersten piezoelektrischen Aktors oder die Simulation des ersten piezoelektrischen Aktors gewonnene Impedanz des geplanten piezoelektrischen Aktors durch das elektrische Netzwerk 3 nachgeahmt werden.

Obwohl zuvor der Aufbau des elektrischen Netzwerks 3 mittels passiver Bauelemente beschrieben wurde, können in dem elektrischen Netzwerk 3 auch aktive Bauelemente zum Einsatz kommen.

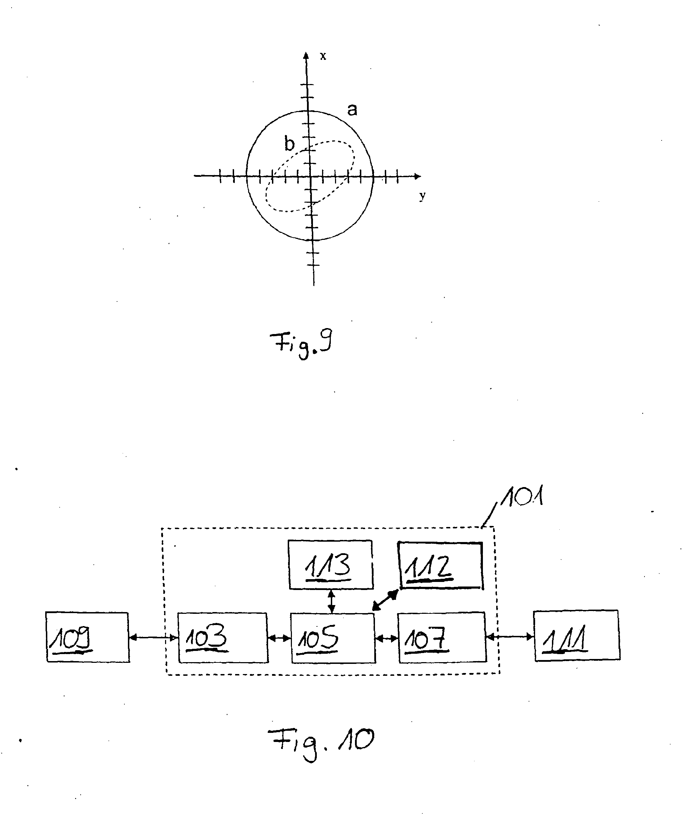

In Figur 9 sind beispielhafte Trajektorien, die mittels der Spitze 23 abgefahren werden können, dargestellt. Die Trajektorie (a) stellt eine kreisförmige, symmetrische Bewegung dar. Innerhalb der Ebene können jedoch andere beliebige Trajektorien abgefahren werden. So zeigt die Trajektorie (b) eine elliptische Form, wobei bei einem Emulationsvorgang die Trajektorie nicht statisch sein muss, sondern sich auch im Laufe der Zeit verändern kann, z.B. sich im Uhrzeigersinn drehen oder ihre Form ändern kann.

Zusammenfassend ermöglicht es der Emulator 1 beliebige, insbesondere piezoelektrische, Antriebe nachzuahmen. Insbesondere die Verwendung der zweiten Regel- und/oder Steuereinheit in Form des PCs 13 ermöglicht es, dass Profile von verschiedenen Antrieben messtechnisch erfasst werden und sofort zugreifbar auf dem PC gespeichert werden, um bei Bedarf auf den Emulator 1, insbesondere in den Mikrocontroller 5, geladen zu werden. Dabei bietet der Emulator 1 den Vorteil, dass mittels des Emulators 1 der gewünschte Antrieb direkt nachgeahmt werden kann, ohne dass dessen sonstige Eigenschaften wie Alterung oder Verschleiß sich negativ bei der Emulation des Antriebs auswirken.

Insbesondere ermöglicht es der Emulator 1, dass der Schwerpunkt der Emulation auf die Funktion des geplanten piezoelektrischen Aktors ausgerichtet wird, ohne dass die Notwendigkeit einer Berücksichtigung von Fertigungstoleranzen oder ähnliches besteht. Entsprechende Funktionen des Aktors sind insbesondere welche Bewegungsamplitude ein geplanter Antrieb erreichen kann und ob diese für die gewünschte Anwendung ausreichen; wie sich Fertigungstoleranzen auswirken können und wie sich ein Verschleiß des Aktors auf einen Reibkontakt auswirken kann. So lässt insbesondere die Vermessung eines realen Prototypen eines geplanten piezoelektrischen Aktors oder eines aus einer laufenden Serienfertigung entnommenen Aktors zu, dass sich anhand der mit dem Emulator durchgeführten Testläufe Aussagen über die bei den realen Aktoren auftretenden Toleranzen treffen lassen. Insbesondere bei Einsatz eines zweiten piezoelektrischen Aktors, der hohe Grenzfrequenzen bzw. hohe Resonanzfrequenzen aufweist, können die zuvor beschriebenen neuartigen Aktorsysteme nachgeahmt bzw. emuliert werden.

Obwohl anhand der Figuren 1 bis 9 das erfindungsgemäße Verfahren und die erfindungsgemäße Vorrichtung anhand der Emulation eines piezoelektrischen Aktors beschrieben wurde, ist die Erfindung nicht auf die Emulation derartiger Aktoren beschränkt. So ermöglicht die erfindungsgemäße Vorrichtung und das erfindungsgemäße Verfahren die Emulation beliebiger Antriebe, beispielsweise auch die Emulation eines Verbrennungsmotors, eines Elektromotors, eines Elektromagneten, eines elektrostatischen Aktors, eines magnetostriktiven Aktors oder eines elektroaktiven Polymers. Dabei ist die Emulation dieser Aktoren nicht darauf beschränkt, dass ein Aktor dadurch emuliert wird, dass der zweite bzw. emulierende Aktor ein Aktor des gleichen Wirkungsprinzips ist. So ist es möglich, dass ein erster bzw. zu emulierender Aktor in Form eines Verbrennungsmotors durch einen zweiten Aktor bzw. emulierenden Aktor in Form eines Elektromotors emuliert wird. Der emulierende und der emulierte Aktor bzw. Antrieb müssen also nicht die gleiche Bauart, Bauform oder das gleiche Wirkungsprinzip aufweisen. Es müssen jedoch technische Daten bezüglich definierter Schnittstellen bzw. Größen, z.B. der Einkopplung einer mechanischen Leistung in eine Last bzw. eines elektrischen Anschlusses an eine Ansteuerelektronik, beachtet werden. Lediglich bezüglich dieser definierten Schnittstellen müssen der erste bzw. emulierte Aktor und der emulierende bzw. zweite Aktor vergleichbar sein. Weiterhin sollte der emulierende Aktor bzw. die Vorrichtung zur Emulation identische oder bessere Leistungsdaten bezüglich dieser Größen aufweisen.

Besonders vorteilhaft ist dabei, wenn verschiedene Aktorprofile in der ersten bzw. zweiten Steuer- und/oder Regeleinheit abgelegt werden können und so von der erfindungsgemäßen Vorrichtung diese verschiedenen Aktorprofile abgerufen und für den Emulationsvorgang verwendet werden können. Dabei kann insbesondere vorgesehen sein, dass ein Wechsel zwischen verschiedenen Aktorprofilen während eines Emulationsvorgangs durchgeführt wird. Dies bedeutet insbesondere, dass die jeweiligen Parameter des elektrischen Netzwerkes in Abhängigkeit von einem in die Steuer- und/oder Regeleinheit geladenen Aktorprofils angepasst werden. Das Ablegen der verschiedenen Aktorprofile kann die Selektion von verschiedenen Antriebsvarianten zur Beurteilung einer Leistungsfähigkeit ermöglichen. So kann vorgesehen sein, dass mittels der erfindungsgemäßen Vorrichtung unterschiedliche Aktoren emuliert werden und ein geeigneter Aktor ausgewählt wird, indem durch "trial and error" ein Aktor gefunden wird, der bestimmten Anforderungen genügt.

Diese Eigenschaft der erfindungsgemäßen Vorrichtung bzw. erfindungsgemäßen Verfahrens bietet den Vorteil, dass es möglich wird, dass ein erforderliches oder von einem Kunden gewünschter Aktor nicht in ein Endgerät verbaut werden muss, um die Eigenschaften des Endgeräts zu prüfen. So kann eine erfindungsgemäße Vorrichtung in ein System, welches eine Emulationseinheit umfasst, integriert sein. Dabei handelt es sich bei der Emulationseinheit insbesondere um das entsprechende Endgerät, wie ein Kraftfahrzeug. Statt einen bestimmten Aktor in das Endgerät einzubauen, kann in die Emulationseinheit eine erfindungsgemäße Vorrichtung verbaut werden, mittels der die für das Endgerät, beispielsweise das Kraftfahrzeug, angebotenen Aktoren bzw. Antriebsvarianten, nachgeahmt werden können. Diese nicht an den Kunden verkauft werdende Emulationseinheit kann die Eigenschaften aller angebotenen Antriebsvarianten nachahmen.

Dazu kann eine erfindungsgemäße Vorrichtung, die in eine Emulationseinheit verbaut werden kann, den in Figur 10 dargestellten Aufbau aufweisen. Die erfindungsgemäße Vorrichtung in Form des Emulators 101 weist ein elektrisches Netzwerk 103, eine erste Steuer- und/oder Regeleinheit in Form eines Mikrocontrollers 105 sowie einen zweiten Aktor 107 und eine zweite Steuer- und/oder Regeleinheit 113 auf. Der Emulator 101 empfängt ein durch eine Ansteuerelektronikschaltung 109 generiertes Ansteuersignal und überträgt eine mechanische Leistung auf eine Last 111, wie eine Antriebseinheit der Emulationseinheit. Bei dem zweiten Emulator 107 kann es sich insbesondere um einen Elektromotor handeln. Der Emulator 101 ist jedoch dazu geeignet, nicht nur Aktoren nachzuahmen, die den gleichen Bautyp wie der zweite Aktor 107 aufweisen, sondern es ist beispielsweise möglich, dass mittels des Emulators 101 ein Verbrennungsmotor emuliert wird. Bei Einbau des Emulators 101 in eine Emulationseinheit in Form eines Kraftfahrzeugs können so bei einer Probefahrt mit dem Kraftfahrzeug verschiedene Antriebsvarianten eingestellt werden, so dass ein Fahrer des Kraftfahrzeugs verschiedene Varianten des Antriebs, beispielsweise einen 4-Zylinder-Antrieb oder ein V12-Antrieb, testen kann. Um die Eigenschaften des Emulationssystems bzw. der Emulationseinheit, insbesondere das Fahrzeug nicht zu beeinflussen, kann vorgesehen sein, dass das System eine Energieversorgungseinheit aufweist, die als von der Emulationseinheit getrennte Einheit ausgebildet ist. So könnten die Eigenschaften eines Kraftfahrzeugs, wie eine Beschleunigung des Fahrzeugs durch das Gewicht und den Platzbedarf einer Energieversorgungseinheit, wie z.B. Batterien beim Einsatz eines Elektromotors als zweiter Aktor, beeinflusst werden. Um dies zu verhindern, kann die Energieversorgung ausgelagert sein, also zum Beispiel in einem Begleitfahrzeug angeordnet sein, wobei die Emulationseinheit bzw. des Emulationsfahrzeug und die Energieversorgungseinheit miteinander durch z.B. Kabel verbunden sind. Hierbei ist es insbesondere positiv, wenn das Begleitfahrzeug bezüglich der Distanz und Relativgeschwindigkeit zum Emulationsfahrzeug von dem Emulator gesteuert bzw. geregelt wird.

Ein derartiges System ermöglicht jedoch nicht nur die Emulation bereits vorhandener Antriebe, sondern es kann auch insbesondere für die Ermittlung von Anforderungen an einen zu entwickelnden Antrieb eingesetzt werden. So kann der Emulator in der Emulationseinheit verbaut werden, da die Eigenschaften des Emulators durch einen Kunden beliebig, geändert werden können, insbesondere gewünschte Leistungen und Leistungsabstufungen festgelegt werden können. Diese stehen dann als Randbedingungen für den nachfolgenden Bau eines Antriebs für das Fahrzeug zur Verfügung. Das System kann also insbesondere dadurch gekennzeichnet sein, dass mittels der Veränderung einer abgegebenen Leistung des Emulators anhand von objektiven und/oder subjektiven Kriterien eine bevorzugte Leistung bzw. Leistungsabstufungen von Antriebsvarianten festgelegt werden kann.

Bei der Emulation verschiedener Antriebskonzepte ist es besonders vorteilhaft, dass der erfindungsgemäße Emulator es ermöglicht auch Eigenschaften von Zusatzaggregaten, wie Bremsen, Kupplung oder Getriebe eines Fahrzeugs, durch Ermittlung der dadurch entstehenden Einflüsse und Berücksichtigung dieser Einflussparameter durch die erfindungsgemäße Vorrichtung mit emuliert werden können. In einer besonders bevorzugten Ausführungsform der Erfindung kann der Aktor 101 eine Vibrationserzeugungseinrichtung 112 aufweisen, die insbesondere mit der ersten Steuer- und Regeleinheit 105 in Wirkverbindung stehen kann. Diese ermöglicht es, dass zusätzliche Vibrationen im hörbaren und/oder im nicht hörbaren Bereich, wie sie z.B. durch eine Bewegung von Kolben in einem Verbrennungsmotor, Drehmomentschwankungen oder Geräusche des zu emulierenden Aktors entstehen, nachgeahmt werden. Hierdurch kann ein direkter und objektiver Vergleich zwischen den durch den emulierten Aktor erzeugten nützlichen Eigenschaften, wie Kraft, Drehmomente und Geschwindigkeit, und den parasitären bzw. nicht nützlichen Eigenschaften, z.B. Lärm und mechanischen Vibrationen, wie sie an einer Karosserie eines Kraftfahrzeugs entstehen können, durchgeführt werden. Beispielhaft ermöglicht es der Emulator 101 einen direkten Vergleich zwischen Otto- und Dieselmotoren durchzuführen.

Bezugszeichenliste

| 1 | Emulator |
|---|---|
| 3 | elektrisches Netzwerk |
| 5 | Mikrocontroller |
| 7 | piezoelektrischer Aktor |
| 9 | Ansteuerelektronikschaltung |
| 11, 11' | Last |
| 13 | PC |

| | |
|---|---|
| 15 | Antriebsgrundkörper |
| 17 | Stapelaktor |
| 19 | Gehäuse |
| 21 | Schnittstelle |
| 23 | Spitze |
| 51 | elektrisches Netzwerk |
| 53 | Kopplungsvierpol |
| 55 | mechanisches Netzwerk |
| 101 | Emulator |
| 103 | elektrisches Netzwerk |
| 105 | Mikrocontroller |
| 107 | Aktor |
| 109 | Ansteuerelektronikschaltung |
| 111 | Last |
| 112 | Vibrationserzeugungseinrichtung |
| 113 | Steuer- und/oder Regeleinheit |
| $C, C_n, C_1, C_2, C_3, C_4$ | Kondensator |
| $S_1, S_2, S_3, S_4$ | Schaltungseinrichtung |
| $L_m$ | Induktivität |
| R | Widerstand |
| n | Nachgiebigkeit |
| h | mechanischer Mitgang |
| m | Masse |
| a, b | Trajektorie |

**Patentansprüche**

1.  Vorrichtung (1, 101) zur Emulation eines Antriebs insbesondere eines Fahrzeugmotors, umfassend

    - zumindest ein mit zumindest einer Ansteuerelektronikschaltung (9, 109) verbindbares elektrisches Netzwerk (3, 103), und
    - zumindest eine Steuer-und/oder Regeleinheit (5,105), und
    - zumindest einen Aktor (7,107),
    wobei das elektrische Netzwerk (3, 103) mittels der zumindest einen ersten Steuer-und/ oder Regeleinheit (5, 105) in Wirkverbindung mit dem zumindest einen Aktor (7, 107) steht,
wobei der Aktor in den technischen Daten bezüglich definiertes Schrittstellen mit dem zu emulierenden Antrieb vergleichbar ist und
wobei die Steuer- und/oder Regeleinheit derart ausgelegt ist, dass mittels der Steuer- und/oder Regeleinheit (5, 105) zumindest ein erster Parameter des elektrischen Netzwerks (3, 103) derart veränderbar ist, dass sich technische Daten der Vorrichtung ergeben, die denen des zu emulierenden Antriebs insbesondere eines Fahrzeugmotors entsprechen.

2. Vorrichtung nach Anspruch 1, **dadurch gekennzeichnet, dass** in der Steuer-und/oder Regeleinheit verschiedene Profile eines Fahrzeugmotors abrufbar abgelegt sind.

3. Vorrichtung nach Anspruch 2, **dadurch gekennzeichnet, dass** der zumindest eine Parameter des elektrischen Netzwerkes in Abhängigkeit eines in der Steuer- und/oder Regeleinheit abgelegten Profils anpassbar ist.

4. Vorrichtung nach einem der vorangegangenen Ansprüche, **dadurch gekennzeichnet, dass** der Aktor (7) mit zumindest einem Sensor zur Erfassung zumindest einer Auslenkung des Aktors (7) in zumindest eine Raumrichtung und/oder zur Erfassung zumindest einer Trajektorie einer Verbindungsvorrichtung (23) insbesondere in Form einer auswechselbaren Spitze in Wirkverbindung steht.

5. Vorrichtung nach einem der vorangehenden Ansprüche, **dadurch gekennzeichnet, dass** mittels des elektrischen Netzwerks (3, 103) zumindest eine elektrische Impedanz des zu emulierenden Fahrzeugmotors derart emulierbar ist, dass bei Ansteuerung des Aktors (7) die Vorrichtung (1) zumindest eine elektrische Impedanz des zu emulierenden Fahrzeugmotors aufweist.

6. Vorrichtung nach einem der vorangehenden Ansprüche, **dadurch gekennzeichnet, dass** das elektrische Netzwerk (3) zumindest eine Elementarzelle umfassend zumindest eine erste elektrische Kapazitätseinrichtung und eine zu der ersten elektrischen Kapazitätseinrichtung (C) parallel geschaltete Reihenschaltung aus zumindest einer elektrischen Induktivitätseinrichtung, zumindest einer zweiten elektrischen Kapazitätseinrichtung und/oder zumindest einer ersten elektrischen Widerstandseinrichtung aufweist.

7. Vorrichtung nach Anspruch 6, **dadurch gekennzeichnet, dass** die Elementarzelle und/oder zumindest eine der Elementarzellen zumindest eine zweite elektrische Widerstandseinrichtung (RL) umfasst, wobei die zweite elektrische Widerstandseinrichtung (RL) veränderlich ist und zumindest ein Halbleiterbauelement umfasst.

8. System mit

  - einer Vorrichtung nach einem der vorangegangenen Ansprüche in Form einer Emulationseinheit und
  - einer Energieversorgungseinheit,
  **dadurch gekennzeichnet, dass** die Energieversorgungseinheit getrennt von der Emulationseinheit ausgebildet ist, in Form eines von der Emulationseinheit getrennten Fahrzeugs und/oder die Energieversorgungseinheit und die Emulationseinheit in Form unterschiedlicher Fahrzeugtypen ausgebildet sind.

9. Vorrichtung oder System nach einem der vorangegangenen Ansprüche,
  **dadurch gekennzeichnet, dass** das System oder die Vorrichtung zumindest eine Vibrationserzeugungseinrichtung (112) umfasst, wobei die Vibrationserzeugungseinrichtung (112) ausgelegt ist, um Vibrationen auf die Emulationseinheit und/oder den Aktor der Emulationseinheit zu übertragen und/oder wobei die Vibrationserzeugungseinrichtung (112) ausgelegt ist Vibrationen im Infraschallbereich, im hörbaren Bereich, im nicht hörbaren Bereich und/oder im Ultraschallbereich zu erzeugen.

10. Verfahren zur Emulation eines zu emulierenden Antriebs, wobei das Verfahren umfasst:

  - Bereitstellung zumindest eines Aktors (7, 107) und zumindest eines mit dem Aktor (7, 107) zur Emulierung zumindest einer Impedanz des zu emulierenden Antriebs in Wirkverbindung stehenden elektrischen Netzwerks (3, 103), wobei der Aktor in den technischen Daten bezüglich definierter Schnittstellen mit dem zu emulierenden Antriebs vergleichbar ist, und
  - Einstellen zumindest eines ersten Parameters des elektrischen Netzwerks (3, 103) in Abhängigkeit von zumindest einem zweiten Parameter des zu emulierenden Antriebs.

**11.** Verfahren zur Emulation eines zu emulierenden Antriebs in Form eines Fahrzeugmotors, wobei das Verfahren umfasst:

- Bereitstellung zumindest eines Aktors wobei der Aktor in den technischen Daten bezüglich definierter Schnittstellen mit dem zu emulierenden Antriebs vergleichbar ist, (7, 107) und zumindest eines mit dem Aktor (7, 107) zur Emulierung zumindest einer Impedanz des zu emulierenden Fahrzeugmotors in Wirkverbindung stehenden elektrischen Netzwerks (3, 103), und
- Einstellen zumindest eines ersten Parameters des elektrischen Netzwerks (3, 103) in Abhängigkeit von zumindest einem zweiten Parameter des zu emulierenden Antriebs in Form eines Fahrzeugmotors.

**12.** Verfahren nach einem der Ansprüche 10 und 11, **dadurch gekennzeichnet, dass** der zweite Parameter mittels zumindest einer Simulation des zu emulierenden Antriebs, zumindest einer analytischen Modellierung des zu emulierenden Antriebs und/oder zumindest einer Vermessung eines Prototypen und/oder eines aus einer laufenden Serie entnommenen Exemplars des zu emulierenden Antriebs bestimmt wird und/oder als zweiter Parameter zumindest ein Übertragungsfaktor (X, Y) des zu emulierenden Antriebs bestimmt wird.

**13.** Verfahren nach einem der Ansprüche 10 bis 12, **dadurch gekennzeichnet, dass** das Einstellen des ersten Parameters das Einstellen zumindest eines Kapazitätswertes einer ersten elektrischen Kapazitätseinrichtung (C) und/oder zumindest einer zweiten elektrischen Kapazitätseinrichtung (Cn) des elektrischen Netzwerkes (3), zumindest eines Induktivitätswertes einer Induktivitätseinrichtung (Lm) des elektrischen Netzwerkes (3) und/oder zumindest eines Widerstandswertes einer ersten elektrischen Widerstandseinrichtung (R) und/oder zumindest einer zweiten elektrischen Widerstandeinrichtung (RL) umfasst.

**14.** Verfahren nach einem der Ansprüche 10 bis 13, **dadurch gekennzeichnet, dass** durch eine Auswertung einer ersten Bewegung des Aktors (7, 107) zumindest ein dritter Parameter des zu emulierenden Antriebs bestimmt wird, wobei als dritter Parameter zumindest ein Zusammenhang zwischen zumindest einem Spannungswert, zumindest einem Frequenzwert und/oder zumindest einem Stromwert des Ansteuerungssignals einerseits und zumindest eines Auslenkungswertes, zumindest eines Beschleunigungswertes, zumindest eines Kraftwertes zumindest einer über den Aktor aufgebauten Kraft und/oder zumindest eines Leistungswertes des Aktors (7, 107) andererseits bestimmt wird.

**15.** Verfahren nach einem der Ansprüche 10 bis 14, **dadurch gekennzeichnet, dass** der dritte Parameter verwendet wird, um eine Simulation, insbesondere eine Finite-Elemente-Methode (FEM)-Simulation, des zu emulierenden Antriebs und/oder zumindest einer analytischen Modellierung des zu emulierenden Antriebs durchzuführen.

**16.** Verfahren nach einem der Ansprüche 10 bis 15, **dadurch gekennzeichnet, dass** mittels der Emulation Leistungseigenschaften, wie eine mechanische Leistung, Vibrationseigenschaften, wie Vibrationen im hörbaren und/oder nicht hörbaren Bereich, und/oder Antriebseigenschaften, wie eine Bewegungsgleichmäßigkeit, des zu emulierenden Antriebs emuliert werden.

**17.** Verfahren nach einem der Ansprüche 10 bis 16, **dadurch gekennzeichnet, dass** mittels des Verfahrens neben der Emulation des zu emulierenden Antriebs zumindest ein mit dem zu emulierenden Antriebs zumindest indirekt in Wirkverbindung stehendes Zusatzaggregat, wie zumindest ein Getriebe, zumindest eine Bremse und/oder eine Kupplung, emuliert wird.

**18.** Verfahren nach einem der Ansprüche 10 bis 17, **dadurch gekennzeichnet, dass** während eines Emulationsvorgangs, insbesondere durch Beeinflussung des ersten Parameters, des zweiten Parameters und/oder eines vierten Parameters, in Abhängigkeit von in der ersten Steuer- und/oder Regeleinheit abgespeicherten Aktorprofilen unterschiedliche zu emulierende Antriebe emuliert werden.

**Claims**

**1.** A device (1, 101) for emulating a drive, in particular of a vehicle engine, comprising

- at least one electric network (3, 103), which may be connected to at least one control electronic circuit (9, 109) and
- at least one control unit (5, 105) and

- at least one actuator (7, 107),

wherein the electric network (3, 103) is operatively connected to the at least one actuator (7, 107) by the at least one first control unit (5, 105),

wherein the actuator has comparable technical data to the drive, which is to be emulated, with respect to defines interfaces, and

wherein the control unit is designed in such a manner that at least a first parameter of the electric network (3, 103) may be changed by the control unit (5, 105) so as to result in technical data of the device, which correspond to those of the drive, which is to be emulated, in particular of a vehicle engine.

2. The device according to claim 1, **characterized in that** different profiles of a vehicle engine are stored in the control unit so as to be capable of being recalled.

3. The device according to claim 2, **characterized in that** the at least one parameter of the electric network may be adapted as a function of a profile, which is stored in the control unit.

4. The device according to one of the preceding claims, **characterized in that** the actuator (7) is operatively connected to at least one sensor for detecting at least one deflection of the actuator (7) in at least one spatial direction and/or for detecting at least one trajectory of a connecting device (23), in particular in the form of an exchangeable tip.

5. The device according to one of the preceding claims, **characterized in that** at least one electric impedance of the vehicle engine, which is to be emulated, may be emulated by the electric network (3, 103) in such a manner that the device (1) encompasses at least one electric impedance of the vehicle engine, which is to be emulated, in response to the controlling of the actuator (7).

6. The device according to one of the preceding claims, **characterized in that** the electric network (3) comprising at least one elementary cell, the at least one elementary cell comprises at least a first electric capacitance arrangement and a series connection, which is connected parallel to the first electric capacitance arrangement (C) and which comprises at least one electric inductance arrangement, at least a second electric capacitance arrangement and/or at least a first electric resistance arrangement.

7. The device according to claim 6, **characterized in that** the elementary cell and/or at least one of the elementary cells comprises at least a second electric resistance arrangement (RL), wherein the second electric resistance arrangement (RL) is changeable and comprises at least one semiconductor component.

8. A system comprising

- a device according to one of the preceding claims in the form of an emulation unit and
- a power supply unit,

**characterized in that** the power supply unit is embodied so as to be separated from the emulation unit, in the form of a vehicle, which is separated from the emulation unit and/or **in that** the power supply unit and the emulation unit are embodied in the form of different vehicle types.

9. The device or system according to one of the preceding claims, **characterized in that** the system or the device comprises at least one vibration generating mechanism (112), wherein the vibration generating mechanism (112) is designed to transfer vibrations to the emulation unit and/or the actuator of the emulation unit and/or wherein the vibration generating mechanism (112) is designed to generate vibrations in the infrasound range, in the audible range, in the inaudible range and/or in the ultrasonic range.

10. A method for emulating a drive, which is to be emulated, wherein the method comprises:

- providing at least one actuator (7, 107) and at least one electric network (3, 103), which is operatively connected to the actuator (7, 107) for emulating at least one impedance of the drive, which is to be emulated, wherein the actuator has comparable technical data to the drive, which is to be emulated, with respect to defines interfaces, and
- adjusting at least a first parameter of the electric network (3, 103) as a function of at least a second parameter of the drive, which is to be emulated.

**11.** A method for emulating a drive, which is to be emulated, in the form of a vehicle engine, wherein the method comprises:

- providing at least one actuator, wherein the actuator has comparable technical data to the drive, which is to be emulated, with respect to defines interfaces, (7, 107) and at least one electric network (3, 10), which is operatively connected to the actuator (7, 107) for emulating at least one impedance of the vehicle engine, which is to be emulated and
- adjusting at least a first parameter of the electric network (3, 103) as a function of at least a second parameter of the drive, which is to be emulated, in the form of a vehicle engine.

**12.** The method according to one of claims 10 and 11, **characterized in that** the second parameter is determined by at least one simulation of the drive, which is to be emulated, at least one analytic modeling of the actuator, which is to be emulated, and/or at least one measuring of a prototype and/or of a copy, which is taken from a current series, of the actuator, which is to be emulated and/or at least one transfer factor (X, Y) of the drive, which is to be emulated, is determined as second parameter.

**13.** The method according to one of claims 10 to 12, **characterized in that** the adjusting of the first parameter comprises the adjusting of at least one capacitance value of the a first electric capacitance arrangement (C) and/or of at least a second electric capacitance arrangement (Cn) of the electric network (3), of at least one inductance value of an inductance arrangement (Lm) of the electric network (3) and/or of at least one resistance value of a first electric resistance arrangement (R) and/or of at least a second electric resistance arrangement (RL).

**14.** The method according to one of claims 10 to 13, **characterized in that** at least a third parameter of the drive, which is to be emulated, is determined by an evaluation of a first movement of the actuator (7, 107), wherein on the one hand at least one context between at least one voltage value, at least one frequency value and/or at least one current value of the control signal is determined as third parameter and, on the other hand, at least one deflection value, at least one acceleration value, at least one force value of at least one force built up via the actuator and/or of at least one performance value of the actuator (7, 107) is determined.

**15.** The method according to one of claims 10 to 14, **characterized in that** the third parameter is used to perform a simulation, in particular a finite elements method (FEM) simulation of the drive, which is to be emulated, and/or at least one analytic modeling of the drive, which is to be emulated.

**16.** The method according to one of claims 10 to 15, **characterized in that** performance characteristics, such as a mechanical performance, vibration characteristics, such as vibrations in the audible and/or inaudible range and/or drive characteristics, such as a constancy of movement of the drive, which is to be emulated, are emulated by the emulation.

**17.** The method according to one of claims 10 to 16, **characterized in that**, in addition to the emulation of the drive, which is to be emulated, at least one additional unit, which is at least in indirect operative connection to the drive, which is to be emulated, such as at least one transmission, at least one brake and/or a coupler is emulated by the method.

**18.** The method according to one of claims 10 to 17, **characterized in that** different drives, which are to be emulated, are emulated during an emulation process, in particular by influencing the first parameter, the second parameter and/or a fourth parameter as a function of actuator profiles, which are stored in the first control unit.

**Revendications**

**1.** Dispositif (1, 101) pour émuler un mécanisme d'entraînement, en particulier un moteur de véhicule, comportant :

- au moins un réseau électrique (3, 103) pouvant être relié à au moins un circuit électronique de commande (9, 109), et
- au moins une unité de commande et/ou de régulation (5, 105), et
- au moins un actionneur (7, 107),
dans lequel le réseau électrique (3, 103) est en liaison active avec le au moins un actionneur (7, 107) au moyen de la au moins une première unité de commande et/ou de régulation (5, 105),
dans lequel l'actionneur peut être comparé au mécanisme d'entraînement à émuler en utilisant les données techniques relatives à des interfaces définies, et

dans lequel l'unité de commande et/ou de régulation est adaptée de telle sorte qu'au moins un premier paramètre du réseau électrique (3, 103) peut être changé au moyen de l'unité de commande et/ou de régulation (5, 105) de manière à obtenir des données techniques du dispositif qui correspondent à celles du mécanisme d'entraînement à émuler, en particulier d'un moteur de véhicule.

2. Dispositif selon la revendication 1, **caractérisé en ce que** différents profils d'un moteur de véhicule peuvent être récupérés dans l'unité de commande et/ou de régulation.

3. Dispositif selon la revendication 2, **caractérisé en ce que** le au moins un paramètre du réseau électrique peut être adapté en fonction d'un profil archivé dans l'unité de commande et/ou de régulation.

4. Dispositif selon l'une quelconque des revendications précédentes, **caractérisé en ce que** l'actionneur (7) est en liaison active avec au moins un capteur pour détecter au moins une déviation de l'actionneur (7) dans au moins une direction spatiale et/ou pour détecter au moins une trajectoire d'un dispositif de liaison (23) ayant en particulier la forme d'une pointe échangeable.

5. Dispositif selon l'une quelconque des revendications précédentes, **caractérisé en ce qu'**au moins une impédance électrique du moteur de véhicule à émuler peut être émulée au moyen du réseau électrique (3, 103) de telle sorte que lors de la commande de l'actionneur (7), le dispositif (1) comporte au moins une impédance électrique du moteur de véhicule à émuler.

6. Dispositif selon l'une quelconque des revendications précédentes, **caractérisé en ce que** le réseau électrique (3) comporte au moins une cellule élémentaire comportant au moins des premiers moyens électriques capacitifs et un circuit série raccordé en parallèle aux premiers moyens électriques capacitifs (C), ledit circuit série étant constitué d'au moins des moyens électriques inductifs, d'au moins des seconds moyens électriques capacitifs et/ou d'au moins des premiers moyens électriques résistifs.

7. Dispositif selon la revendication 6, **caractérisé en ce que** la cellule élémentaire et/ou au moins une des cellules élémentaires comporte au moins des seconds moyens électriques résistifs (RL), dans lequel les seconds moyens électriques résistifs (RL) sont variables et comportent au moins un composant à semi-conducteur.

8. Système comportant :

- un dispositif selon l'une quelconque des revendications précédentes sous la forme d'une unité d'émulation et
- une unité d'alimentation en énergie,
**caractérisé en ce que** l'unité d'alimentation en énergie est configurée séparée de l'unité d'émulation, sous la forme d'un véhicule séparé de l'unité d'émulation et/ou l'unité d'alimentation en énergie et l'unité d'émulation sont configurées sous la forme de différents types de véhicule.

9. Dispositif ou système selon l'une quelconque des revendications précédentes, **caractérisé en ce que** le système ou le dispositif comporte au moins des moyens de génération de vibrations (112), dans lequel les moyens de génération de vibrations (112) sont conçus pour transmettre des vibrations à l'unité d'émulation et/ou à l'actionneur de l'unité d'émulation et/ou dans lequel les moyens de génération de vibrations (112) sont conçus pour générer des vibrations dans le domaine infrasonore, dans le domaine audible, dans le domaine non audible et/ou dans le domaine ultrasonore.

10. Procédé pour émuler un mécanisme d'entraînement à émuler, le procédé comportant les étapes consistant à :

- préparer au moins un actionneur (7, 107) et au moins un réseau électrique (3, 103) en liaison active avec l'actionneur (7, 107) pour émuler au moins une impédance du mécanisme d'entraînement à émuler, dans lequel l'actionneur peut être comparé au mécanisme d'entraînement à émuler en utilisant les données techniques relatives à des interfaces définies, et
- ajuster au moins un premier paramètre du réseau électrique (3, 103) en fonction d'au moins un deuxième paramètre du mécanisme d'entraînement à émuler.

11. Procédé pour émuler un mécanisme d'entraînement à émuler ayant la forme d'un moteur de véhicule, le procédé comportant les étapes consistant à :

- préparer au moins un actionneur (7, 107) et au moins un réseau électrique (3, 103) en liaison active avec l'actionneur (7, 107) pour émuler au moins une impédance du moteur de véhicule à émuler, dans lequel l'actionneur peut être comparé au mécanisme d'entraînement à émuler en utilisant les données techniques relatives à des interfaces définies, et

- ajuster au moins un premier paramètre du réseau électrique (3, 103) en fonction d'au moins un deuxième paramètre du mécanisme d'entraînement à émuler ayant la forme d'un moteur de véhicule.

**12.** Procédé selon l'une quelconque des revendications 10 et 11, **caractérisé en ce que** le deuxième paramètre est déterminé au moyen d'au moins une simulation du mécanisme d'entraînement à émuler, d'au moins une modélisation analytique du mécanisme d'entraînement à émuler et/ou d'au moins une mesure d'un prototype et/ou d'un exemplaire prélevé sur une série actuelle du mécanisme d'entraînement à émuler, et/ou au moins un facteur de transfert (X, Y) du mécanisme d'entraînement à émuler est déterminé en tant que deuxième paramètre.

**13.** Procédé selon l'une quelconque des revendications 10 à 12, **caractérisé en ce que** l'ajustement du premier paramètre comporte l'ajustement d'au moins une valeur de capacité de premiers moyens électriques capacitifs (C) et/ou d'au moins de seconds moyens électriques capacitifs (Cn) du réseau électrique (3), d'au moins une valeur d'inductance de moyens inductifs (Lm) du réseau électrique (3) et/ou d'au moins une valeur de résistance de premiers moyens électriques résistifs (R) et/ou d'au moins de seconds moyens électriques résistifs (RL).

**14.** Procédé selon l'une quelconque des revendications 10 à 13, **caractérisé en ce qu'**au moins un troisième paramètre du mécanisme d'entraînement à émuler est déterminé par une évaluation d'un premier mouvement de l'actionneur (7, 107), dans lequel au moins un rapport entre, d'une part, au moins une valeur de tension, au moins une valeur de fréquence et/ou au moins une valeur de courant du signal de commande et, d'autre part, au moins une valeur de déviation, au moins une valeur d'accélération, au moins une valeur de force d'au moins une force appliquée sur l'actionneur et/ou au moins une valeur de puissance de l'actionneur (7, 107), est déterminé en tant que troisième paramètre.

**15.** Procédé selon l'une quelconque des revendications 10 à 14, **caractérisé en ce que** le troisième paramètre est utilisé pour effectuer une simulation, en particulier une simulation par la méthode des éléments finis (FEM), du mécanisme d'entraînement à émuler et/ou au moins une modélisation analytique du mécanisme d'entraînement à émuler.

**16.** Procédé selon l'une quelconque des revendications 10 à 15, **caractérisé en ce que** des caractéristiques de puissance telles qu'une puissance mécanique, des caractéristiques de vibration telles que des vibrations dans le domaine audible et/ou non audible, et/ou des caractéristiques d'entraînement telles qu'une régularité de mouvement, du mécanisme d'entraînement à émuler, sont déterminées au moyen de l'émulation.

**17.** Procédé selon l'une quelconque des revendications 10 à 16, **caractérisé en ce que**, en plus l'émulation du mécanisme d'entraînement à émuler, au moins un ensemble supplémentaire au moins indirectement en liaison active avec le mécanisme d'entraînement à émuler, tel qu'au moins une boîte de vitesses, au moins un frein et/ou un accouplement, est émulé au moyen du procédé.

**18.** Procédé selon l'une quelconque des revendications 10 à 17, **caractérisé en ce que** lors d'un processus d'émulation, différents mécanismes d'entraînement à émuler sont émulés, notamment en faisant varier le premier paramètre, le deuxième paramètre et/ou un quatrième paramètre en fonction de profils d'actionneur mémorisés dans la première unité de commande et/ou de régulation.

Fig. 1

Fig. 2a

Fig. 2b

Fig. 3

$$\begin{pmatrix} u \\ i \end{pmatrix} = \begin{pmatrix} X \\ Y \end{pmatrix}\begin{pmatrix} v \\ F \end{pmatrix}$$

Fig. 4a

$$\begin{pmatrix} 0 & Y \\ \dfrac{1}{Y} & 0 \end{pmatrix}$$

Fig. 4b

Fig. 5

Fig. 6

Fig. 7

Fig. 8

Fig.9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 04140080 A
- JP 2005164369 A